# EUROPEAN PATENT APPLICATION

(11) **EP 4 733 729 A1**
(43) Date of publication of application: **29.04.2026**
(21) Application number: 25208800.0
(22) Date of filing: 15.10.2025
(51) Int. Cl.: G01L 9/00, B81B 3/00

(54) **PRESSURE SENSOR HAVING HIGH DETECTION PERFORMANCE AND OPTIMIZED MANUFACTURING**

(30) Priority: 28.10.2024 IT 202400024015
(71) Applicant: STMicroelectronics International N.V., 1228 Plan-les-Ouates, Geneva (CH)
(72) Inventor: DANIELE, Filippo, 20864 AGRATE BRIANZA (MB) (IT); BALDO, Lorenzo, 20864 AGRATE BRIANZA (MB) (IT); ADORNO, Silvia, 20864 AGRATE BRIANZA (MB) (IT); NICOLI, Silvia, 20864 AGRATE BRIANZA (MB) (IT); PREVIDI, Anita, 20864 AGRATE BRIANZA (MB) (IT)
(74) Representative: Studio Torta S.p.A.

(57) **Abstract**

A pressure sensor (30) has a substrate (31); a deformable detection element (38) suspended on the substrate, extending at a distance from the substrate along a first direction (Z), and configured to undergo a deformation as a function of a pressure to be detected; and an anchoring structure (30) configured to support the deformable detection element (38) over the substrate. The anchoring structure has a plurality of anchoring portions (50) extending from the substrate (31), coupled to the deformable detection element (38), and arranged at a distance from each other along a second direction (Y) transversal to the first direction (Z); and a structural region (51) extending between the anchoring portions along the second direction (Y) and having at least one release opening (55).

## Description

### Technical Field

The present invention relates to a pressure sensor, in particular of the MEMS ("Micro Electro-Mechanical System") type, having high detection performance and optimized manufacturing.

### Background

MEMS pressure sensors are known having a membrane configured to deform as a function of an external pressure to be measured. By detecting the deformation of the membrane, for example through capacitive detection, a measurement of the external pressure may be obtained.

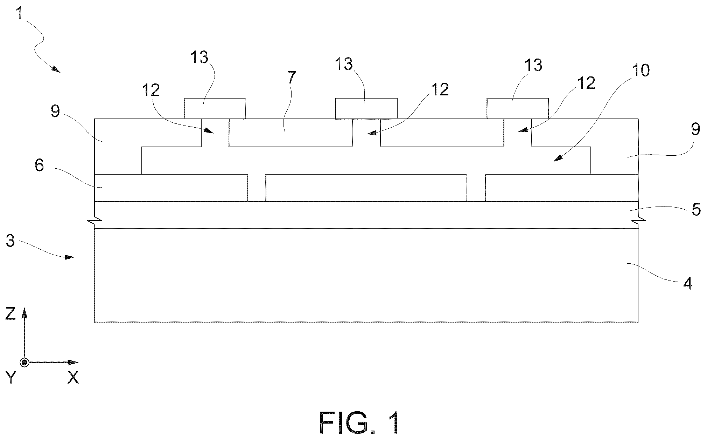

Figure 1 shows, in a Cartesian reference system XYZ, a known example of a MEMS pressure sensor 1 comprising a substrate 3 that is formed by a semiconductor layer 4, an insulating layer 5 on the semiconductor layer 4, and a conductive layer 6 on the insulating layer 5.

A membrane 7 of semiconductor material is suspended on the substrate 3, at a distance from the conductive layer 6 along a Z axis.

The membrane 7 is supported by an anchoring structure 9 that extends from the substrate 3 along the Z axis and is coupled to the membrane 7.

The membrane 7 faces, along the Z axis, the conductive layer 6 and a buried cavity 10 extends between the membrane 7 and the conductive layer 6.

The buried cavity 10 is sealed towards the outside, i.e. it is hermetically separated from the area of the pressure sensor 1 that extends above the membrane 7 and is at the external pressure to be detected. In this manner, the membrane 7 deforms as a function of the difference between the external pressure to be detected and the pressure of the buried cavity.

The pressure sensor 1 further comprises release openings 12 that extend through the membrane 7, throughout the thickness of the membrane 7 along the Z axis. The release openings 12 allow the manufacture of the buried cavity 10.

Sealing regions 13 of insulating material extend over the release openings 12 and are configured to seal the release openings 12, so as to maintain the tightness of the buried cavity 10.

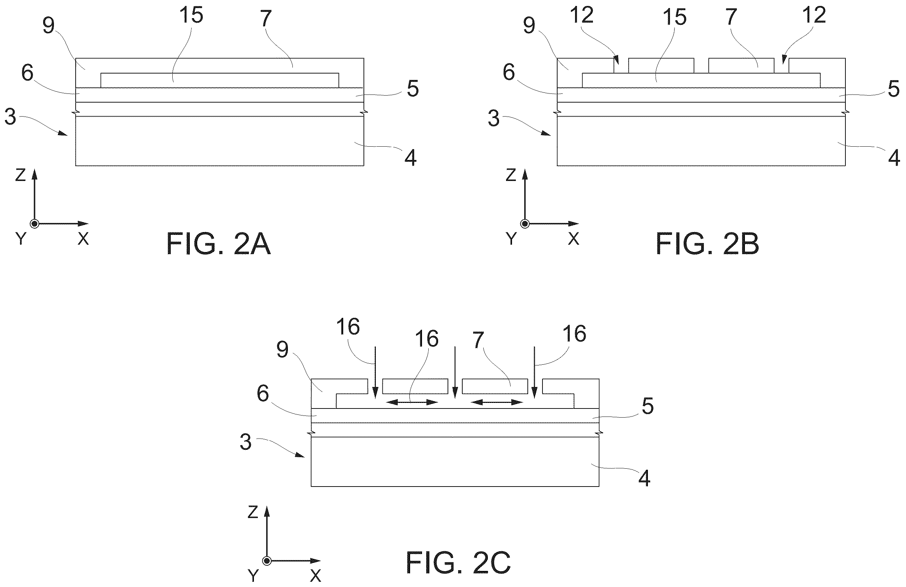

In fact, as shown in detail in Figures 2A-2C, a known approach to forming the buried cavity 10 envisages the formation of a sacrificial layer 15 of oxide (Figure 2A), the formation of the release openings 12 (Figure 2B), and a chemical etching (indicated by arrows 16 in Figure 2C) performed through the release openings 12 for removing the sacrificial layer 15.

The presence of the release openings 12 through the membrane 7, and therefore close to the sacrificial layer 15, allow to speed up the step of removing the sacrificial layer 15 of Figure 2C.

However, the presence of the sealing regions 13 in contact with the membrane 7 may cause a residual mechanical stress (for example caused by the difference in thermal expansion coefficient between membrane 7 and sealing regions 13) in the membrane 7 and therefore may alter the elastic deformation behavior of the membrane 7.

The pressure sensor 1 therefore has low detection performance.

The aim of the present invention is to overcome the disadvantages of the prior art.

### Summary

According to the present invention, a pressure sensor and a manufacturing process are therefore provided, as defined in the attached claims.

### Brief Description of the Drawings

For a better understanding of the present invention, embodiments thereof are now described, purely by way of nonlimiting example, with reference to the attached drawings, wherein:
- Figure 1 shows a cross-section of a known MEMS pressure sensor;
- Figures 2A-2C show successive manufacturing steps of the MEMS pressure sensor of Figure 1;
- Figure 3 shows a top-plan view of a MEMS pressure sensor, according to one embodiment;
- Figure 4 shows a cross-section of the MEMS pressure sensor of Figure 3, along a section line IV-IV of Figure 3;
- Figure 5 shows a top-plan view of an enlarged portion of the MEMS pressure sensor of Figure 3;
- Figure 6 shows a cross-section of a portion of the MEMS pressure sensor of Figure 3, along a section line VI-VI of Figure 5;
- Figure 7 shows a cross-section of a portion of the MEMS pressure sensor of Figure 3, along a section line VII-VII of Figure 5;
- Figure 8 shows a cross-section of a portion of the MEMS pressure sensor of Figure 3, along a section line VIII-VIII of Figure 5;
- Figures 9A, 10A, 11A, 12A show successive manufacturing steps relating to the portion of Figure 7 of the pressure sensor of Figure 3, according to one embodiment; and
- Figures 9B, 10B, 11B, 12B show successive manufacturing steps relating to the portion of Figure 8 of the pressure sensor of Figure 3, according to one embodiment.

### Description of Embodiments

The following description refers to the arrangement shown in the attached Figures; consequently, expressions such as "above", "below", "lower", "upper", "right", "left", "top", "bottom", and the like, relate to the attached Figures and are not to be interpreted in a limiting manner.

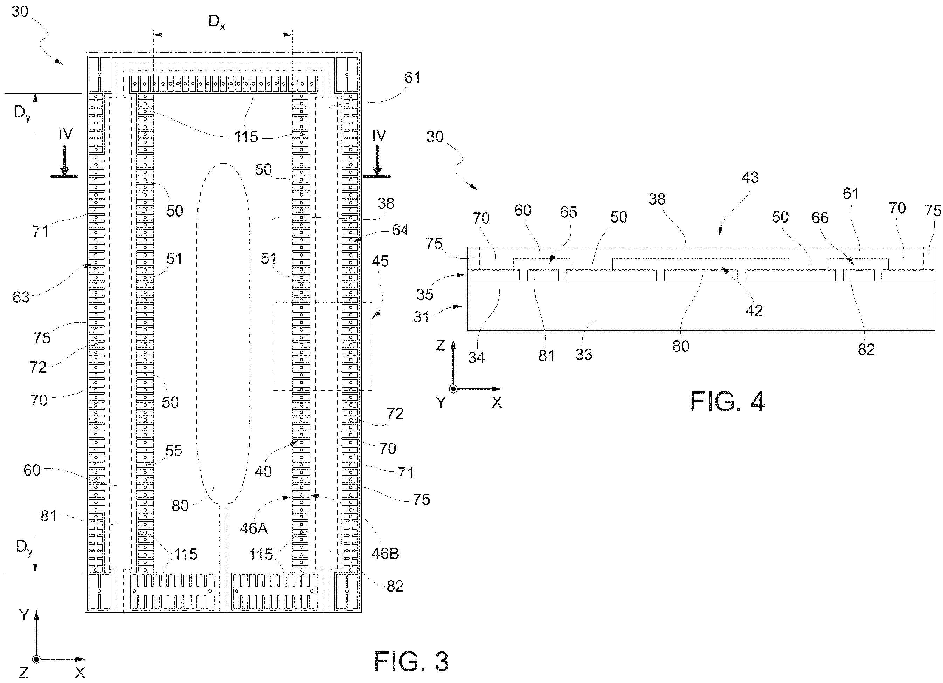

Figures 3 and 4 show a pressure sensor 30, hereinafter also referred to simply as sensor 30, in a Cartesian reference system XYZ having an X axis, a Y axis and a Z axis.

The sensor 30 is of a MEMS type.

The sensor 30 may be manufactured through micro- and nano-processing techniques, for example starting from a wafer of semiconductor material, in particular silicon, and successive processing steps, for example including lithography, chemical etching, growth, annealing, dicing, bonding, etc.

The sensor 30 is a capacitive-type sensor.

The sensor 30 comprises a substrate 31, which may be obtained by dicing a wafer of semiconductor material.

In detail, the substrate 31 comprises a semiconductor layer 33 of semiconductor material, for example silicon; an insulating layer 34 of insulating or dielectric material, for example silicon oxide, which extends on the semiconductor layer 33; and a conductive layer 35, in particular of suitably doped semiconductor material, for example polysilicon, which extends on the insulating layer 34.

The insulating layer 34 may be superimposed in whole or in part on the semiconductor layer 33 and the conductive layer 35 may be superimposed in whole or in part on the insulating layer 34, depending on the specific layout of the sensor 30 and the specific manufacturing process used.

The sensor 30 comprises a detection membrane 38 suspended on the substrate 31, at a distance from the substrate 31 along the Z axis; and an anchoring structure 40 which is configured to support the detection membrane 38 over the substrate 31.

The detection membrane 38 may be in whole or in part of semiconductor material, in particular of silicon or polysilicon, suitably doped depending on the specific application.

In practice, the detection membrane 38 faces, at a distance, the conductive layer 35 and is configured to be capacitively coupled to the conductive layer 35. In other words, the detection membrane 38 forms an upper electrode, and the portion of conductive layer 35 facing the detection membrane 38 forms a lower electrode capacitively coupled to the upper electrode.

The detection membrane 38 is configured to undergo a deformation (along the Z axis in the embodiment shown), as a function of the external pressure to be detected.

In detail, the sensor 30 further comprises a buried cavity 42 that extends between the detection membrane 38 and the substrate 31. In particular, in the embodiment of Figure 4, the buried cavity 42 extends below the detection membrane 38.

The buried cavity 42 is sealed with respect to an area 43 of the sensor 30 that is exposed to the external pressure to be detected; i.e., in the embodiment of Figure 4, of the area 43 that is arranged above the detection membrane 38, on the opposite side of the buried cavity 42 with respect to the reference membrane 38.

The detection membrane 38 is configured to undergo a deformation along the Z axis that is a function of the difference between the external pressure to be detected (above the detection membrane 38) and the pressure of the buried cavity 42 (below the detection membrane 38).

In detail, the dimensions (surface on an XY plane and thickness along the Z axis) of the detection membrane 38 may be adjusted, during the design step, as a function of the desired detection characteristics.

In particular, the detection membrane 38 has, with reference to the plan view of Figure 3, a horizontal width Dₓ (measured parallel to the X axis) and a vertical width D_{y} (measured parallel to the Y axis). In the embodiment of Figure 3, the detection membrane has, in a top-plan view, a rectangular shape and Dₓ<D_{y}; therefore, the horizontal width Dₓ may be defined as a characteristic dimension of the detection membrane 38.

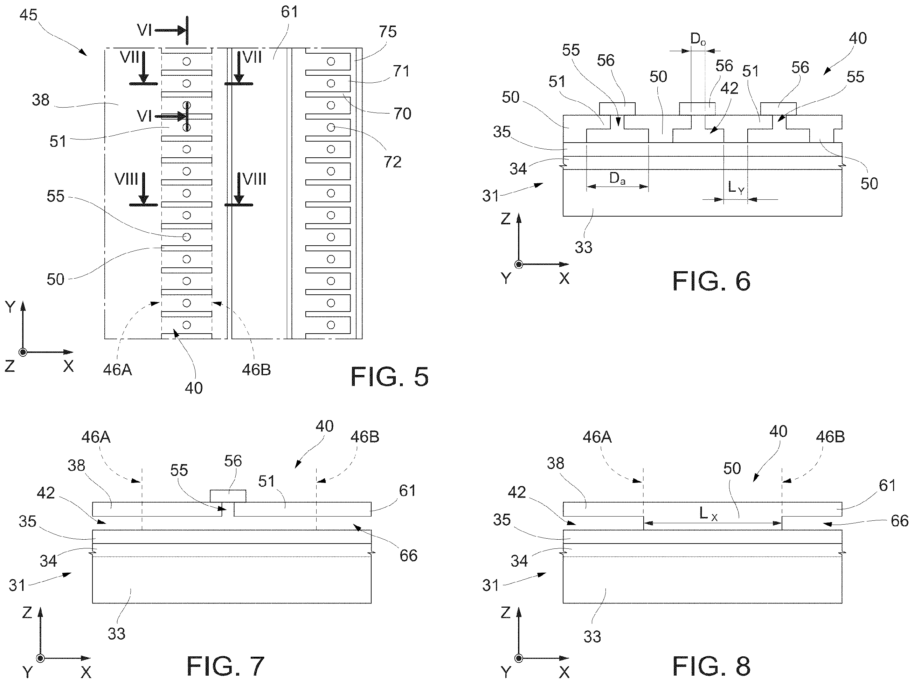

The anchoring structure 40 will be described in detail below with reference to Figures 5-8, which show an enlarged portion 45 of the anchoring structure 40.

The anchoring structure 40 extends around the detection membrane 38.

In detail, the anchoring structure 40 defines the detection membrane 38 and defines its respective dimensions Dₓ, D_{y}.

The anchoring structure 40 has an internal face 46A adjacent to the detection membrane 38, i.e. which faces towards the inside of the detection membrane 38; and an external face 46B which is opposite with respect to the internal face 46A.

In practice, the internal face 46A defines the perimeter of the detection membrane 38.

The internal face 46A and the external face 46B extend around the detection membrane 38, surrounding it at least partially.

For illustrative clarity, in Figures 3 and 5-8, the internal face 46A and the external face 46B of the anchoring structure 40 are indicated by a dashed line.

In detail, the anchoring structure 40 comprises a plurality of anchoring portions 50 and a structural region that is formed by a plurality of structural portions 51.

The anchoring portions 50 extend from the substrate 31, in particular each along respective directions parallel to the Z axis and are coupled to the reference membrane 38.

In detail, the anchoring portions 50 are fixed to the substrate 31 and to the detection membrane 38; in particular, they have a first end fixed to the substrate 31, in contact therewith, and a second end that is opposite to the first end along the Z axis and fixed to the detection membrane 38, in contact therewith.

The anchoring portions 50 each extend along a respective longitudinal axis that is transversal to the internal face 46A; in particular, the anchoring portions 50 each extend between the internal face 46A and the external face 46B of the anchoring structure 40.

The anchoring portions 50 have a width L_{X}, measured along the respective longitudinal axis between the internal face 46A and the external face 46B (i.e. along the X axis with reference to the enlarged portion 45 of Figure 5), comprised for example between 5 µm and 30 µm.

The anchoring portions 50 are arranged from each other at a distance Dₐ along a transversal axis that is transversal to the respective longitudinal axis, i.e. along the Y axis with reference to the enlarged portion 45 of Figure 5.

The distance Dₐ may be comprised for example between 1 µm and 10 µm.

The anchoring portions 50 each have a width L_{Y}, measured along the respective transversal axis, comprised for example between 0.5 µm and 5 µm.

The width L_{X} may be greater than the width L_{Y}, which may improve the support provided to the detection membrane 38 and confer high robustness to the anchoring structure 40.

The ratio between the width L_{X} and at least one of the dimensions Dₓ, D_{y} of the reference membrane 38 (in particular, the ratio L_{X}/Dₓ between the width L_{X} and the characteristic dimension Dₓ of the reference membrane 38) may be greater than 4% and in particular comprised between 4% and 20%, and/or the ratio between the distance Dₐ and at least one of the dimensions Dₓ, D_{y} of the reference membrane 38 (in particular, the ratio Dₐ/Dₓ between the distance Dₐ and the characteristic dimension Dₓ of the reference membrane 38) may be lower than 8% and in particular comprised between 0.8% and 8%. Such relationships may contribute to improving the robustness of the anchoring provided by the anchoring structure 40 to the detection membrane 38.

The structural portions 51 each extend between two adjacent anchoring portions 50, in particular parallel to the respective transversal axis (along the Y axis in the enlarged portion of Figure 5).

In detail, each structural portion 51 is suspended on the substrate 31, i.e. at a distance from the substrate 31 along the Z axis, and is carried by the two adjacent anchoring portions 50 parallel to the transversal axis of the anchoring portions 50.

The structural portions 51 therefore face along the Z axis on the substrate 31, each above a respective buried cavity that is in fluidic communication with the buried cavity 42 and therefore indicated again by 42.

The structural portions 51 also extend between the internal face 46A and the external face 46B of the anchoring structure 40.

In particular, in the embodiment of Figure 5, each structural portion 51 extends throughout the width L_{X} of the respective anchoring portions 50. Therefore, on the side of the internal face 46A, the structural portions 51 are contiguous to the detection membrane 38.

However, the structural portions 51 may have, along the longitudinal axis of the anchoring portions 50, a different width, in particular smaller, than the width Lx.

The structural portions 51 may be formed from the same structural layer used to form the detection membrane 38.

The structural region 51 comprises a plurality of release openings 55, useful for manufacturing the sensor 30 and in particular the buried cavity 42 and the detection membrane 38. In particular, in the embodiment shown, each structural portion 51 comprises a respective release opening 55.

The release openings 55 each extend throughout the thickness of the respective structural portion 51 measured along the Z axis. In other words, the release openings 55 are through-openings passing through the structural portions 51 and are in fluidic communication with the underlying buried cavity 42.

In Figure 5, the release openings 55 are circular holes; however, the release openings 55 may have a different shape, for example polygonal (in particular rectangular or square), depending on the specific layout or the specific manufacturing steps.

The release openings 55 have a width Dₒ, measured along the transversal axis (e.g., Y axis) between two adjacent anchoring portions 50, comprised for example between 0.3 µm and 1 µm.

In detail, the width Dₒ is smaller than the distance Dₐ, which ensures that the release openings 55 extend, during manufacturing, over the area forming the buried cavity 42, avoiding opening holes over the anchoring portions 50.

The difference between the distance Dₐ and the width Dₒ may depend on the misalignment between the lithographic masks used for the formation of the release openings 55 and the lithographic masks used for the formation of the anchoring portions 50. In particular, maintaining Dₐ-Dₒ ≥ 0.5 µm may ensure high manufacturing reliability.

The anchoring structure 40 further comprises a plurality of sealing portions 56 configured to seal the release openings 55 and, therefore, the buried cavity 42 from the area 43 overlying the reference membrane 38.

The sealing portions 56 each extend on a respective structural portion 51, over and at a respective release opening 55.

The sealing portions 56 may be of a material different from the material of the structural portions 51; in particular, of a material etchable through a class of chemical compounds different from that usable for chemically etching the structural portions 51.

For example, the sealing portions 56 may be of oxide, oxynitride or nitride.

Again with reference to Figures 3 and 4, the sensor 30 may comprise one or more reference membranes, in this embodiment two reference membranes 60, 61.

The reference membranes 60, 61 may be optional.

The reference membranes 60, 61 extend to the side of the detection membrane 38. In the embodiment shown, the reference membranes 60, 61 extend externally to the detection membrane 38, respectively to the left and right of the detection membrane 38 along the X axis.

The reference membranes 60, 61 are suspended on the substrate 31, at a distance therefrom along the Z axis, and are each supported by respective anchoring structures.

In detail, the reference membrane 60 is supported, on the side of the detection membrane 38 (on the right in Figure 3), by a portion of the anchoring structure 40 of the detection membrane 38 and, on the opposite side, by a dedicated anchoring region 63. The reference membrane 61 is supported, on the side of the detection membrane 38 (on the left in Figure 3), by a portion of the anchoring structure 40 of the detection membrane 38 and, on the opposite side, by a dedicated anchoring region 64.

A buried cavity 65 extends between the reference membrane 60 and the substrate 31, below the reference membrane 60. A buried cavity 66 extends between the reference membrane 61 and the substrate 31, below the reference membrane 61.

The buried cavities 65, 66 may be in fluidic communication with each other and with the buried cavity 42; this may simplify the manufacture of the sensor 30 and reduce the overall area occupancy of the sensor 30.

The reference membranes 60, 61 are configured not to undergo a deformation (at least as a first approximation) as a function of the external pressure to be detected; i.e., with reference to Figure 4, in order not to undergo a deformation as a function of the difference between the pressure of the area 43 overlying the membranes 60, 61 and the pressure of the underlying buried cavities 65, 66.

In the embodiment shown, the reference membranes 60, 61 have a smaller surface than that of the detection membrane 38; in particular, the characteristic dimension of the reference membranes 60, 61 (i.e., the horizontal dimension measured parallel to the X axis) may be smaller than the characteristic dimension Dₓ of the detection membrane 38.

The reference membranes 60, 61 may be useful to obtain differential detection of the external pressure to be detected and thus improve the detection performance of the sensor 30.

The reference membranes 60, 61 may be formed from the same layer used to form the detection membrane 38 and the structural portions 51.

The anchoring regions 63, 64 of the reference membranes 60, 61 have a structure similar to that of the anchoring structure 40; in fact, also the anchoring regions 63, 64 each comprise respective anchoring portions 70, respective structural portions 71 and respective release openings 72.

The anchoring region 63 has a respective internal face, which is arranged towards the reference membrane 60 and forms a perimeter side of the reference membrane 60, and an external face, which is arranged on the opposite side of the internal face at a distance from the reference membrane 60 along the X axis. The anchoring region 64 has a respective internal face, which is arranged towards the reference membrane 61 and forms a perimeter side of the reference membrane 61, and an external face, which is arranged on the opposite side of the internal face at a distance from the reference membrane 61 along the X axis.

What has been described with regards to the anchoring portions 50, the structural portions 51 and the release openings 55 (e.g., dimensions and arrangement) also applies *mutatis mutandis* to the anchoring portions 70, the structural portions 71 and the release openings 72.

Respective sealing portions, not shown here, extend on the structural portions 71 of the anchoring regions 63, 64, at the release openings 72, such as to seal the buried cavities 65, 66 at the top.

The sensor 30 further comprises a perimeter sealing element 75 that extends from the substrate 30 around the perimeter side of the sensor 30, i.e., so as to surround the membranes 38, 60, 61.

The perimeter sealing element 75 is configured to laterally seal the buried cavities 42, 65, 66.

In detail, in the embodiment shown, the perimeter sealing element 75 is coupled to the anchoring portions 70 of the reference membranes 60, 61.

The conductive layer 35 comprises portions 80, 81, 82 (identified by a dashed line in Figure 3) which are defined in the conductive layer 35 through respective openings, as for example visible in Figure 4. The portions 80, 81, 82 form the lower electrodes capacitively coupled to the detection membrane 38, to the reference membrane 60 and, respectively, to the reference membrane 31 and also form respective connection tracks for coupling with an external detection circuit, not shown here.

The fact that the release openings 55 are part of the anchoring structure 40 and are arranged between the anchoring portions 50 causes the release openings 55 to be external to the detection membrane 38. In this manner, the deformation characteristics of the detection membrane 38 are not influenced by the presence of the release openings 55.

Furthermore, the sealing portions 56 also do not extend in contact with the detection membrane 38; this further contributes to ensuring high detection performance of the sensor 30.

In addition, the fact that the release openings are placed inside the anchoring structure 40 causes the release openings 55 to be arranged close to the detection membrane 38 and the buried cavity 42, for example, closer with respect to the case in which the release openings are formed externally to the anchoring structure of the membrane; this allows the manufacturing of the sensor 30 to be optimized, as discussed in detail below, and the manufacturing costs of the sensor 30 to be reduced.

Hereinafter, an embodiment of a manufacturing process of the pressure sensor 30 will be described, with reference to steps useful for understanding the present invention. However, the manufacturing process may comprise further steps known per se to the person skilled in the art and therefore not described.

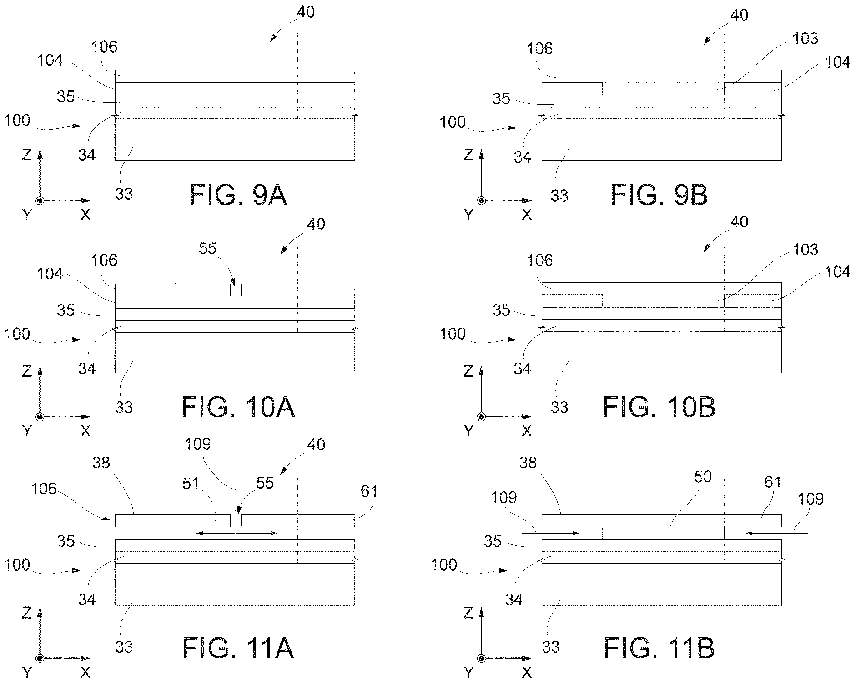

The manufacture of the sensor 30 will be described with reference to a portion of the sensor 30 at the anchoring structure 40 of the detection membrane 38; in detail, with reference to Figures 9A, 10A, 11A and 12A as regards the section of Figure 7 and with reference to Figures 9B, 10B, 11B and 12B as regards the section of Figure 8.

Figures 9A and 9B show a wafer 100, intended to form the substrate 31, comprising the semiconductor layer 33, the insulating layer 34 and the conductive layer 35.

On the conductive layer 35 there are formed, for example by growth or deposition, a lower structural layer 103, for example of semiconductor material such as silicon or polysilicon; and a sacrificial layer 104, of material different from that of the lower structural layer 103, for example of oxide (in particular, silicon oxide).

The lower structural layer 103 extends in contact with the conductive layer 35 and is patterned so as to form a lower part of the anchoring portions 50.

The lower structural layer 103 may also be patterned so as to form the lower part of the anchoring portions 70 and/or the perimeter sealing element 75.

The sacrificial layer 104 is used for forming the buried cavity 42.

In this embodiment, the sacrificial layer 104 is also used for forming the buried cavities 65, 66.

The sacrificial layer 104 then extends in the zones wherein it is desired to form the buried cavities 42, 65, 66.

The sacrificial layer 104 may be of a material removable by chemical etching using a class of chemical compounds different from that usable for etching the lower structural layer 103 and/or the conductive layer 35. This may ensure greater reliability of the manufacturing process.

In addition, an upper structural layer 106 is formed, for example by growth or deposition, on the lower structural layer 103 and on the sacrificial layer 104.

The upper structural layer 106 may be of the same material as the lower structural layer 103.

In particular, the sacrificial layer 104 may be formed before the structural layers 103 and 106, and the structural layers 103, 106 may be formed (for example, deposited or grown) together in a same manufacturing step from the portions of the conductive layer 35 exposed by the overlying sacrificial layer 104 previously patterned.

For clarity of illustration, in Figure 9B, the lower structural layer 103 is separated from the upper structural layer 106 by a dashed line.

The detection membrane 38, the structural portions 51, and the upper part of the anchoring portions 50 are formed from the upper structural layer 106.

The reference membranes 60, 61, the structural portions 71, the upper part of the anchoring portions 70, and the perimeter sealing element 75 may also be formed from the upper structural layer 106.

Subsequently, Figures 10A and 10B, the release openings 55 are formed through the upper structural layer 106, for example through lithography and chemical etching steps.

Together with the release openings 55, the release openings 72 may also be formed.

Then, Figures 11A and 11B, the sacrificial layer 104 is removed.

The sacrificial layer 104 is removed through chemical etching, either a dry or wet etching, through the release openings 55 and 72.

The chemical compound used for removing the sacrificial layer 104 penetrates through the release openings 55, 72 and, as indicated by the arrows 109, spreads throughout the zone occupied by the sacrificial layer 104, removing it.

Following the chemical etching of Figures 11A and 11B, the buried cavities 42, 65, 66 are then formed, and therefore consequently also the membranes 38, 60, 61 and the structural portions 51, 71.

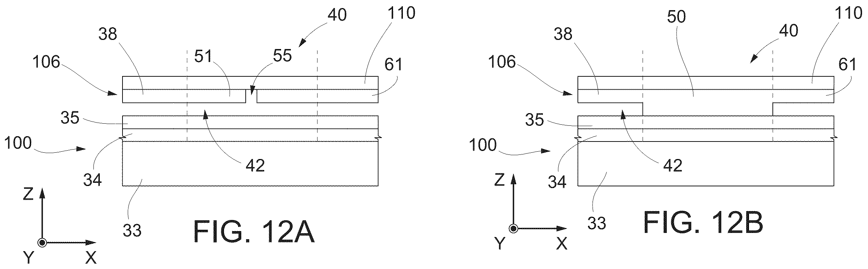

Then, Figures 12A and 12B, a sealing layer 110, for example of oxide, nitride or oxynitride, is deposited over the structural layer 106, such that it extends over the release openings 55 (and 72), without entering inside the release openings 55 (and 72) and inside the buried cavities 42, 65, 66.

The sealing layer 110 may be a monolayer, or a multilayer comprising for example materials that are different from each other, depending on the specific application.

The sealing layer 110 may have a thickness comprised for example between 0.5 µm and 4 µm; in this manner, it is possible to favour the formation of the sealing layer 110 in a continuous manner above the release openings 55 and therefore ensure correct sealing.

In a manner not shown, the sealing layer 110 is then patterned, through lithography and chemical etching steps, so as to form the sealing portions 56.

In practice, the sealing layer 110 is completely removed from the portions overlying the detection membrane 38. Thus, as discussed above, the sealing portions 56 do not influence the deformation properties of the detection membrane 38.

Furthermore, the presence of the release openings 55 inside the anchoring structure 40 and thus in proximity to the detection membrane 38 allows reducing the etching time for the removal of the sacrificial layer 104 of Figures 11A and 11B.

Further manufacturing steps follow that are known per se and therefore not shown and discussed here, such as for example packaging the wafer 100, forming electrical connections and dicing, which lead to the formation of the pressure sensor 30.

Finally, it is clear that modifications and variations may be made to the sensor 30 and to the respective manufacturing process described and illustrated here without thereby departing from the scope of the present invention, as defined in the attached claims.

For example, the substrate 31 may be formed by layers other than those shown. For example, the layers 33, 34, 35 may be monolayers or multilayers, depending on the specific application. Furthermore, the conductive layer 35 may be of metal material.

Number and arrangement of the anchoring portions 50, the structural portions 51 and the release openings 55 may be different from what has been shown. For example, only some of the structural portions 51 may have the release openings 55.

Additionally or alternatively, the anchoring structure 40 of the reference membrane 38 may have one or more portions devoid of the structural portions 51 and/or the release openings 55.

For example, the anchoring structure 40 may have end portions (top and bottom in Figure 4) having further anchoring elements 115, in addition to the anchoring portions 50, which are fixed to the substrate 31. The further anchoring elements 115 extend parallel to the external sides of the detection membrane 38 and may contribute to improving the support provided to the detection membrane 38.

For example, the sealing portions 56 may form a sealing region comprising portions that are distinct from each other or contiguous to one another, depending on the specific embodiment.

For example, one or more of the detection membrane 38 and the reference membranes 60, 61 may have, in a top-plan view, a different shape from that shown, for example they may have a different number of sides or may have a plan that is circular, elliptical, etc. For example, in case the detection membrane 38 is circular in shape, the characteristic dimension may be defined as the respective diameter.

Furthermore, the detection membrane 38 may be a deformable element of a type and shape different from a membrane, for example cantilevers or other.

Additionally or alternatively, the reference membranes 60, 61 may be suspended elements of a different type, such as for example cantilevers or other.

For example, one or both of the reference membranes 60, 61 may be absent. In this case, the perimeter sealing element that seals the buried cavity 42 laterally may extend at the external face 46B of the anchoring structure 40, in contact with the anchoring portions 50 and the structural portions 51.

For example, the pressure sensor 30 may be configured to detect the deformation of the detection membrane 38 through a transduction mechanism other than the capacitive one, for example of the piezoelectric, piezoresistive type, etc.

Finally, the different embodiments described above may be combined to provide further solutions.

## Claims

1. A pressure sensor (30) comprising:
a substrate (31);
a deformable detection element (38) suspended on the substrate, extending at a distance from the substrate along a first direction (Z), and configured to undergo a deformation as a function of a pressure to be detected; and
an anchoring structure (30) configured to support the deformable detection element (38) over the substrate,
wherein the anchoring structure comprises:
a plurality of anchoring portions (50) extending from the substrate (31), coupled to the deformable detection element (38), and arranged at a distance from each other along a second direction (Y) transversal to the first direction (Z); and
a structural region (51) extending between the anchoring portions along the second direction (Y) and having at least one release opening (55).

2. The pressure sensor according to the preceding claim, wherein the anchoring structure (40) has an internal face (46A) coupled to the deformable detection element (38), the anchoring portions (50) extending from the internal face along a third direction (X) transversal to the first direction (Z) and the second direction (Y), wherein the anchoring portions have a first width (L_{X}) along the third direction (X) and a second width (Ly) along the second direction (Y).

3. The pressure sensor according to the preceding claim, wherein the first width (L_{X}) is greater than the second width (L_{Y}).

4. The pressure sensor according to claim 2 or 3, wherein the deformable detection element (38) has a first dimension (Dₓ) along at least one of the second direction (Y) and the third direction (X), and wherein the ratio (L_{X}/Dₓ) between the first width (L_{X}) of the anchoring portions (50) and the first dimension (Dₓ) is greater than or equal to 4%, in particular comprised between 4% and 20%.

5. The pressure sensor according to any of the preceding claims, wherein the deformable detection element (38) has a second dimension (Dₓ) along at least one of the second direction (Y) and the third direction (X) and wherein the ratio (Dₐ/Dₓ) between the distance (Dₐ) along the second direction (Y) between two adjacent anchoring portions (50) and the second dimension is lower than or equal to 8%, in particular comprised between 0.8% and 8%.

6. The pressure sensor according to any of the preceding claims, wherein the at least one release opening (55) has a width (Dₒ) along the second direction (Y) that is lower than the distance (Dₐ) along the second direction between two adjacent anchoring portions.

7. The pressure sensor according to the preceding claim, wherein the difference (Dₐ-Dₒ) between the width (Dₒ) of the at least one release opening and the distance (Dₐ) between two adjacent anchoring portions is greater than or equal to 0.5 µm.

8. The pressure sensor according to the preceding claim, further comprising a buried cavity (42) arranged between the deformable detection element (38) and the substrate (31), the release opening being in fluidic communication with the buried cavity.

9. The pressure sensor according to any of the preceding claims, further comprising a sealing region (56) configured to seal the at least one release opening (55).

10. The pressure sensor according to the preceding claim, wherein the sealing region (56) extends on the structural region (51) of the anchoring structure (40).

11. The pressure sensor according to any of the preceding claims, further comprising:
at least one suspended reference element (60, 61) suspended on the substrate, at a distance from the substrate along the first direction (Z) and configured not to undergo a deformation as a function of the pressure to be detected; and
a reference anchoring structure (63, 64) configured to support the at least one suspended reference element and arranged at a distance from the anchoring structure of the deformable detection element (38),
wherein the reference anchoring structure (63, 64) comprises:
a respective plurality of anchoring portions (70) extending from the substrate (31), coupled to the suspended reference element (60, 61), and arranged at a distance from each other along the second direction (Y); and
a respective structural region (71) extending between the anchoring portions (70) along the second direction (Y) and having at least one respective release opening (72).

12. A process for manufacturing a pressure sensor (30), comprising, from a wafer (100):
forming a deformable detection element (38) suspended on the wafer, extending at a distance from the wafer along a first direction (Z), and configured to undergo a deformation as a function of a pressure to be detected; and
forming an anchoring structure (30) configured to support the deformable detection element (38) over the substrate,
wherein forming an anchoring structure comprises:
forming a plurality of anchoring portions (50) extending from the wafer (100), coupled to the deformable detection element (38), and arranged at a distance from each other along a second direction (Y) transversal to the first direction (Z); and
forming a structural region (51) extending between the anchoring portions along the second direction (Y) and having at least one release opening (55).

13. The manufacturing process according to the preceding claim, wherein forming the deformable detection element (38) and forming the anchoring structure (40) comprises:
forming a first structural layer (103) and a sacrificial layer (104) on the wafer (100), and a second structural layer (106) on the sacrificial layer and the first structural layer;
forming the at least one release opening (55) in the second structural layer (106), over the sacrificial layer; and
removing the sacrificial layer (104) through the at least one release opening.

14. The manufacturing process according to the preceding claim, further comprising forming, after removing the sacrificial layer, at least one sealing region (56) on the structural region (51) of the anchoring structure (40) and at the at least one release opening (55), the sealing region being configured to seal the at least one release opening.
